# EUROPEAN PATENT SPECIFICATION

(11) **EP 1 916 208 B1**
(45) Date of publication and mention of the grant of the patent: **16.12.2009**
(21) Application number: 06291674.7
(22) Date of filing: 26.10.2006
(51) Int. Cl.: B65H 15/02

(54) **Process and device for handling electronic cards**
Verfahren und Vorrichtung zur Handhabung elektronischer Karten
Procédé et dispositif de manipulation de cartes électroniques

(43) Date of publication of application: 30.04.2008
(73) Proprietor: OBERTHUR TECHNOLOGIES, 92300 Levallois-Perret (FR)
(72) Inventor: Cook, Dave, Tewkesbury Gloucestershire GL20 8DW (GB); Innes, Tim, Ledbury Herefordshire HR8 2FA (GB)
(74) Representative: Bonnans, Arnaud

(56) References cited:
- JP-A- 6 255 729
- US-A- 3 672 118
- US-A- 3 913 774
- US-A1- 2003 103 838
- US-B1- 6 595 740

## Description

The present invention relates to the production of electronic cards, for example microcircuit cards or flash memory cards, and to the handling of large numbers of cards in the process of manufacturing, personalization and/or delivery of these cards.

Cards are widely used and can be of various dimensions, those dimensions being standardized in order to bring compatibility between the various electronic devices using these cards.

Various formats exist for microcircuit cards, among them:
- the ID-1 format as defined by the ISO 7816 standard, used for example, for payment cards. An ID-1 card fits between two concentric rectangles having the following dimensions: 85.72 mm by 54.03 mm for the external rectangle, and 85.46 mm by 53.92 mm for the internal rectangle. Its thickness is 0.76 ± 0.03 mm, and its corners are rounded with radius of 3.18 ± 0.30 mm.
- the ID-000 format as defined by the ISO 7816 standard, used for example for the identification of the subscribers to mobile phone services and referred to as a "plug-in SIM", the initials SIM standing for "Subscriber Identification Module". An ID-000 card also fits between two concentric rectangles having the following dimensions: 25.10 mm by 15.10 mm for the external rectangle and 24.90 mm by 14.90 mm for the internal rectangle. Its thickness is similar to that of an ID-1 card, and its corners are rounded with radius of 1 ± 0.10 mm. The bottom right -hand corner is cut off at an angle of 45° at a distance of 3 mm from the corner of the rectangle.
- the Mini-UICC format, recently introduced in order to replace the ID-000 format (the initials UICC standing for Universal Integrated Circuit Card). This format is described in the technical specification ETSI on physical characteristics of microcircuit cards (see for example ETSI Ts 102 221, v6.4.0 - March 2004, chapter 4).

The microcircuits of the microcircuit cards are smaller than the cards. When the card format is ID-1, the microcircuit is much smaller than the card, and is positioned close from the periphery of the card. When the card format is ID-000, the microcircuit is only a bit smaller than the card, and is positioned close from the middle of the card.

Some microcircuit cards exist with or without contacts, some are dual or hybrid.

Various formats also exist for flash memory cards, among them the MMC (MultiMediaCard) standard, used for example as storage media for portable devices, and the newer SD (Secure Digital card) standard. These cards are rigid.

During the production process, large numbers of cards (typically larger than 10 000) are first manufactured and then processed through one or several personalization steps, depending on their final destination. The personalization steps generally involve graphical personalization or electrical personalization. The cards are then shipped and delivered to the client.

Handling of large numbers of cards between two steps of the production process requires special attention and must meet several requirements. First, the handling process must deal with large numbers of cards, since automation allows cards to be manufactured and personalized very fast (ex: several thousand cards per hour). Second, the cards need to be kept in the same sequence from one step of personalization to another. And third, the orientation of the cards needs to be varied between various steps of manufacturing and personalization in order to meet the requirements of the manufacturing and personalization devices. In particular, cards may have to be flipped upside down between two steps.

One known solution to these requirements is the use of hoppers, i.e., elongated and hollow containers provided with two open extremities and with a section that has a shape and dimensions similar to the shape and dimensions of a card of the standard of interest. Loading and unloading of the cards in a hopper is performed one card at a time, and cards form a stack in the container. Hoppers are usually parallelepipedic. They are made from metal, which makes them expensive. They are used vertically, in which case the correct positioning of the cards in the hopper is helped by gravity.

An important problem is maintaining cards correctly stacked in the hopper and preventing them from falling out of the hopper during its handling and utilization, in particular during loading and unloading. A known solution to this problem is to make the opening in the bottom interface slightly smaller than the section of the cards by means of peripheral, so-called lips that retain the cards in the hopper. In this way the cards are held in the hopper under their own weight.

As mentioned, the production process requires keeping the sequence of the cards unchanged between the different steps of personalization or delivery. To that end, two methods are known for handling a plurality of cards with the known hoppers. Most of the time, the method used includes loading the cards in the hoppers through the top of the hopper and unloading through the bottom of the hopper. And sometimes, another method is used, that includes loading the cards through the bottom and unloading them through the top.

Because of the presence of the lips, when unloading is performed through the bottom interface, gravity is not sufficient to allow the cards to pass through the bottom interface during the unloading step. Similarly, when the loading is performed through the bottom interface, a simple push is not sufficient to allow the cards to pass through the bottom interface during the loading step. Indeed, since the lips of the bottom interface are in the way of the cards during those steps, the cards need to be bent to pass through the interface. This is usually done with an air suction device applied to the middle of the card that forces it to bend and pass through the lips of the interface. The bending deformation is concentrated at the center of the card, while the periphery of the card is less affected. Additionally, when the unloading step is performed through the bottom interface, the bending helps to separate the cards which may be held together by electrostatic charges.

With the two methods described, it is to be noted that the cards have the same face upward after unloading as before loading. This often requires an additional device to put the cards upside down between two steps of the production process. This is for example the case for microcircuit cards, between a moulding step and a personalization step, when the moulding step results in a card having its microcircuit facing downward, and the personalization step requires the microcircuit to face upward, to make it easily accessible to a reading head. The requirement for such an additional machine in the production process is a serious inconvenience because it brings unnecessary complexity, expense and loss of time.

Additionally, handling of cards having small dimensions, like the ID-000 microcircuit cards requires special attention. Of special note, bending movements such as those undergone by larger cards with the known hoppers and the known handling methods would be deleterious for such small cards. First, since the dimensions of the cards are small, the bending required to pass through the lips must be relatively greater than that required for larger cards. Second, since the microcircuit of these cards is close to the middle of the card, it would thus experience a stronger deformation than that experienced by the circuits of larger microcircuit cards. This makes the known handling methods inadequate for small cards such as the ID-000 cards, since hoppers including lips cannot be used.

A known method for making ID-000 cards involves making ID-1 cards, handling those ID-1 cards with the known hoppers and the known handling methods during a complete personalization process, and then trimming these ID-1 cards to the ID-000 format. But such a solution brings unnecessary complexity, expense and loss of time and material. Indeed, it would be desirable to be able to produce these ID-000 cards directly at the right dimension, without the need for an intermediate supporting system, as mentioned for instance in the patent document DE 10130016. But this requires appropriate handling methods.

The current invention seeks a remedy to these problems and proposes a method and device for handling a large number of cards, organized in stacks held in a hopper. The invention allows the orientation of the card during the unloading step to be independent of its orientation during the loading step. Additionally, the invention avoids bending the card, during both loading and unloading. It can thus be applied to small cards like the microcircuit cards of the ID-000 format, and also to the cards of the mini-UICC format. It can also be applied to flash memory cards, like the MMC cards and the SD cards.

According to a general definition of the invention, a method is provided for handling a plurality of electronic cards with a hopper comprising a hollow body with first and second opposite open extremities, including the following steps : the plurality of electronic cards is loaded as a card stack in the hopper through the first open extremity of the hopper in a first configuration where this first open extremity is at a higher level than the second open extremity; the hopper is moved into a second configuration where the second open extremity is at a higher level than the first open extremity, while maintaining the cards inside the hopper; at least a part of the plurality of cards is unloaded through this second open extremity.

The method allows the faces of the cards that are orientated downwards during the loading step to be orientated upwards during the unloading step, without the requirement of an additional device for changing the orientation of the cards.

This result is advantageously obtained while keeping the order of the cards unchanged, which is useful for the production process.

The result is also obtained while maintaining an easy access to the cards in the hopper for the loading and unloading steps.

The result is also obtained while keeping the card stack held under its own weight in the hopper during the loading step, and also during the unloading step.

Preferably, the hopper is at no more than 30° with respect to the vertical, or even substantially vertical, in both the first and second configurations. This allows the cards to be held under their own weight most effectively. Alternatively, the hopper can lean, for example at 30° with respect to the vertical, or 30° with respect to the horizontal.

Various other advantageous characteristics can be used, alone or in combination.

In one aspect of the invention, during the step of moving the hopper into a second configuration where the second extremity is at a higher level than the first extremity while maintaining the cards inside the hopper, the hopper is provided with removable retaining means to limit the movements in translation of the cards after the loading step. Preferably, these retaining means are removed before the unloading step.

This allows the cards to stay organized, and correctly stacked, whatever movement is applied to the hopper during the step of moving the hopper.

This result is advantageously obtained while avoiding the presence of lips on one of the extremities, such as in the hoppers of the prior art. This allows avoiding bending the cards in order to have them pass through the extremity of the hopper.

The method thus allows handling of large numbers of cards with a hopper without having the cards experiencing too strong a deformation of the card, nor having to introduce an additional trimming step, as done in the prior art for the production of ID-000 cards.

Preferably these retaining means include removable caps adapted to fit at least one of the extremities of the hopper. This solution has the advantage of being very easy to implement. Alternatively, removable rods passing though the hopper can be used.

Preferably, these retaining means include removable filling material adapted to fill an empty part of the body of the hopper. This solution has the advantage of being very easy to implement, at low cost. Preferably, this filling material is introduced or removed using compressed air. This allows easy and quick preparation of the hopper for the next step.

In another aspect of the invention, the loading step includes maintaining the upper level of the card stack close to the first extremity with maintaining means introduced through the second extremity of the hopper. This allows easy loading of the cards and correct formation of the card stack in the hopper.

And in another aspect of the invention, the unloading step includes maintaining the upper level of the card stack close to the second extremity with maintaining means introduced through the first extremity of the hopper. This allows easy unloading of the cards.

Preferably, the step of moving the hopper from the first configuration into a second configuration is done manually. This avoids using a costly dedicated machine and also avoids unnecessary complications.

Preferably, the loading step includes using an air suction arm to load the cards. This allows easy handling of the cards during that step. Preferably again, the unloading step includes using an air suction arm to unload the cards, also allowing easy handling of the cards during that step.

In a preferred embodiment of the invention, the step of moving the hopper further includes the step of transferring the hopper to another treatment area after the loading step and before the unloading step. The other treatment area can be the premises of a client. The hopper can be used as a temporary storage element for delivery to the premises of a client for said other treatment. This avoids having to wrap the cards prior to transfer, avoiding unnecessary costs.

In another preferred embodiment of the invention, the step of moving the hopper further includes the step of storing the cards in the hopper after the loading step and before the unloading step. This also avoids unnecessary costs.

Preferably, the method further includes transporting the cards by means of a transport belt after the unloading step. This allows easy access to the cards during subsequent processing steps, and is particularly cheap.

Preferably, the method includes moulding the cards before the loading step. And preferably, the method includes personalizing the cards after the unloading step. When these two characteristics are combined, the said method is a method of production of electronic cards or when the card is provided with a microcircuit, a method of production of microcircuit cards. If flipping the card is required between the moulding and the personalization step, the invention avoids having to flip the cards with a machine, and thus reduces the costs.

This method is particularly adapted to the case where the cards are about 0.8 mm thick and include a microcircuit.

Preferably, these cards include a microcircuit provided with surface contacts. Preferably, these cards are smaller than ID-1 cards. Preferably, the format of these cards is ID-000. Preferably, the cards are mobile phone subscriber identification cards, for example SIM cards.

The method is also particularly adapted to the case where the cards are flash memory cards, for example MMC cards or SD cards.

In another general aspect of the invention, a hopper is provided comprising a hollow body adapted to include a stack of cards of a predetermined format and provided with first and second open opposite extremities, this hopper being movable between a first configuration wherein the first extremity is at a higher level than the second open extremity so that the cards of the stack may be loaded in this hopper through the first open extremity and a second configuration wherein the second extremity is at a higher level than the first open extremity so that at least some of the cards of the stack may be unloaded from the hopper through this second open extremity.

Preferably, the hopper further comprises removable caps adapted to close the extremities. This allows retaining the stack of cards inside the hopper during movements of the hopper.

Preferably, the said removable caps are pronged in order to fit inside the extremities of the hopper.

Preferably, the said removable caps are provided with an orientation means. This allows correct and fast orientation of the hopper.

Preferably, the said removable caps are provided with openings to be traversed by elongated elements intended to bear against the stack of cards.

Preferably, the hopper further comprises removable filling material adapted to fill the hollow body of the hopper in addition to the stack of cards. Preferably, the filling material comprises compressible material, for example, compressible balls.

This allows retention of the stack of cards inside the hopper during movements of the hopper, and is cheap. This is necessary when the hopper is loaded with the end of a batch of cards and is thus not completely full. Otherwise, when the hopper is full of cards, filling material might not be necessary.

Preferably, at least one of the caps has an openable window for the loading of the said filling material.

Preferably, the interior of the body has a shape allowing the cards to be positioned in only one orientation.

This allows correct positioning of the cards inside the hopper.

Preferably, the body is provided with exterior orientation means for distinguishing the extremities from each other. These means can be a print, an engraving or a magnetic print. They can be made to be sensed by an operator or by a machine.

These means allow correct positioning of the hopper for the loading and unloading steps.

In a preferred embodiment, the body of the hopper is adapted to include a stack of cards of the ID-000 format. This allows handling of large numbers of ID-000 cards during the production process, contrary to what is known in the prior art, that discloses that ID-000 cards are prepared by trimming cards of the ID-1 format at a late stage of the personalization process.

Preferably, the hopper body is generally cylinder-shaped. This allows an easier manufacturing process for the hoppers, compared to the hoppers of the prior art. And preferably, the body comprises exterior orientation means for identifying the orientation of the body about its axis. This allows easy location of the cards in their correct orientation, before unloading of the cards.

In a preferred embodiment, the hopper body comprises two complementary longitudinal parts, so that it can be opened longitudinally. This allows easy access to the stack of cards when necessary. This allows also an easier manufacturing process for the hoppers, compared to the hoppers of the prior art.

Preferably, the hopper body is made by moulding, preferably by injection moulding of a polymer-based resin. This reduces the costs of manufacturing of the hoppers.

Preferably, the hopper is made of a plastic material, some part of it being transparent. This allows an operator to see the cards inside the hopper and allows an easy and fast orientation of the hopper before the unloading step.

In a particular embodiment of the invention, the hopper body is provided with an attachment means adapted to cooperate with a corresponding attachment means of at least one other identical hopper. The said attachment means may be a linking means for storage.

According to another general definition of the invention, a hopper assembly is provided, this hopper assembly comprising a hopper as described and further comprising a removable longitudinal maintaining device to be introduced in the hollow body through one extremity of the hopper for maintaining the upper part of the card stack close to the other extremity. Preferably, the removable maintaining device comprises a piston or shaft. Preferably, the removable maintaining device is profiled to allow it to move easily through the filling material.

The combination of the hopper and the maintaining device allows easy loading of the cards in a stack and easy unloading of the cards. This also maintains the cards organized correctly in a stack while introducing the filling material in the empty part of the hopper.

Preferably, at least one of the removable caps has a hole for letting the said maintaining device enter the hopper. This allows the loading step to be performed through the first extremity while in the same time the second extremity bears a cap, and cards are maintained by the maintaining device introduced through the second extremity. This also allows the unloading step to be performed through the second extremity while in the same time the first extremity bears a cap and cards are maintained by the maintaining device introduced through the first extremity..

The invention and its associated advantages will be more clearly apparent from the following description and accompanying drawings, which provide non-limitative examples.

### Brief description of the drawings

Figure 1 is a schematic view of a first step of moulding a microcircuit card.
Figure 2 is a schematic view of such card in a mould.
Figure 3 shows an example of schematic process for a personalization step of a microcircuit card.
Figure 4 is a schematic view of a step of loading electronic cards into a hopper according to the invention.
Figure 5 is a schematic view of a step of introducing filling material into the empty part of the body of a hopper according to the invention.
Figure 6 is a schematic view of a step of removing a maintaining means out of a hopper containing cards and filling material according to the invention.
Figure 7 is a schematic view of a step of moving a hopper from one configuration to another according to the invention.
Figure 8 is a schematic view of a step of removing filling material from the hopper according to the invention.
Figure 9 is a schematic view of a step of unloading cards from a hopper according to the invention.
Figure 10 represents a schematic view of a hopper according to a preferred embodiment of the invention.
Figure 11 shows a schematic view of a hopper according to a preferred embodiment of the invention in an open configuration
Figure 12 shows a schematic view of the cross section of a hopper according to a preferred embodiment of the invention and the positioning of a card in the cross section.
Figure 13 shows a schematic view of a cap of a hopper according to a preferred embodiment of the invention.
Figure 14 shows another schematic view of a cap of a hopper according to a preferred embodiment of the invention
Figure 15 shows two exterior views of a hopper according to a preferred embodiment of the invention.
Figure 16 shows a schematic view of a group of 6 hoppers according to a preferred embodiment of the invention and linked together for storage.

### Detailed description of a preferred embodiment

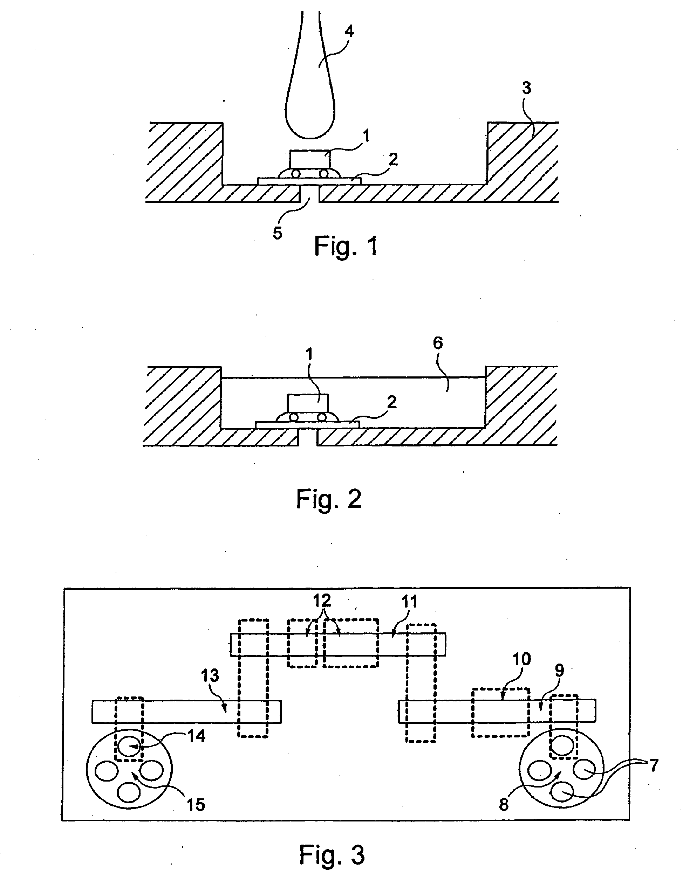

Figures 1 to 3 show some steps of a production cycle of electronic cards, starting in an area with at least moulding steps (Figures 1 and 2), and ending with personalization steps, in practice in another area (Figure 3).

Referring to Figure 1, a microcircuit (1) with its external contacts (2) facing downward is pre-positioned in a mould (3). The mould has shape and dimensions of the type of cards desired, according to the ISO-7816 standard. Some plastic material (4), for example comprising polyurethane resin, is spread in the mould on the microcircuit. A hole (5) in the mould allows the microcircuit to be held in place by an air suction device during the moulding step. The plastic is chosen in order to allow adequate and solid coating of the microcircuit. Its quantity is chosen so that the final thickness of the card is in accordance with the ISO-7816 standard. The moulding step may include a polymerisation step.

Referring to Figure 2, the resulting card (6) lies horizontal in the mould with the external contacts (2) of its microcircuit (1) facing downward. The card is then removed from the mould, using for example an air suction arm.

In practice large numbers of cards are moulded, sometimes as batches. The production of such cards may include additional steps (not shown) which may require some flipping of the cards.

This batch production is in practice followed by individual steps, generally in a different location, possibly on the client premises, where personalisation takes place. An example is given in Figure 3 schematically disclosing both a graphical personalisation step and an electrical personalisation step conducted in a plant. It may be noted that this requires the handling of large numbers of cards and their transport from the batch production area to this plant.

At the end of the moulding step, cards are loaded in a hopper with their external contacts (2) facing downward. Most of the time, the first personalization step requires the cards to have their external contacts facing upward.

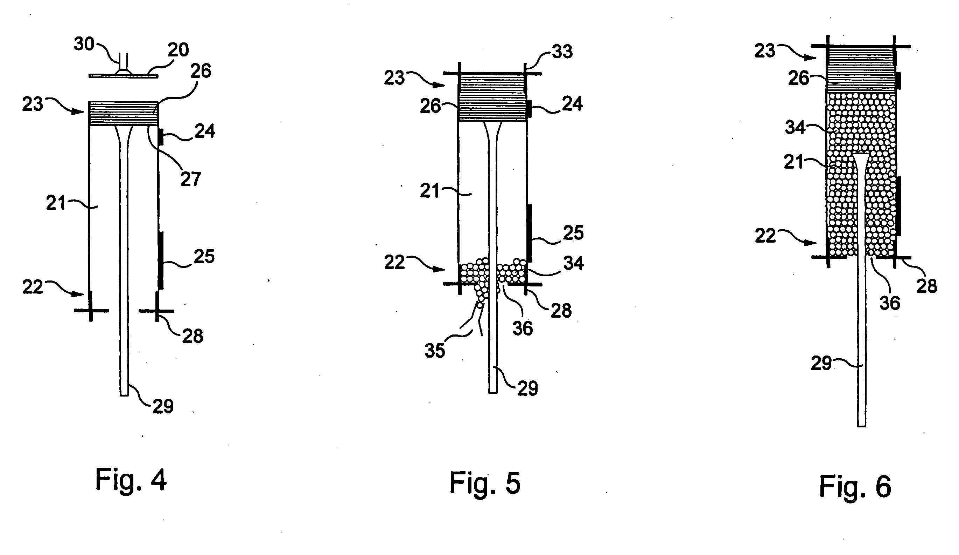

Referring to Figure 3, several hoppers (7) containing cards are used to deliver a plurality of cards for a graphical personalization step. The orientation of the hoppers can be chosen by an operator, according to the invention, and as shown in the following Figures 4 to 9. The hoppers are held on a rotating table (8) allowing empty hoppers to be removed and replaced with fully loaded hoppers. The cards are unloaded one at a time from the top of a hopper (7) and placed onto a primary recessed transport belt (9) where the information contained in the microcircuit is read by a reading device (10) positioned above the transport belt (9). A reading head makes contact with the external contacts of the cards. Depending on the information read, cards are flipped upside down during the subsequent transfer step that brings the cards to a secondary transport belt (11). This flipping step can be performed using a hopper according to the invention, and as described in the Figures 4 to 9. A printing step is then performed by an inkjet head (12) on the face of the card that is orientated upwards at that stage. Cards can then be flipped upside down again during another transfer step that brings them to another transport belt (13). This flipping step can also be performed using a hopper according to the invention, and as described in Figures 4 to 9. The cards are finally removed one at a time from the transport belt and place into an output hopper (14). This hopper is positioned on a rotating table (15) that allows the removal of full hoppers and the loading of empty hoppers.

It may be understood that flipping of the cards may be required at several locations, either during the batch production, or during the personalisation. Such a flipping of the electronic cards is made, according to the invention, with at least a hopper, within a hopper assembly, which are described herein below.

Figure 4 shows the step of loading of a microcircuit card (20) into a hopper (21) according to the invention. The hopper is provided with two opposite open extremities (22) and (23). The hopper (21) is positioned vertically and the operator can distinguish its two extremities using the orientation means (24) and (25). Some cards (26) are loaded in stack inside the hopper. Their faces with external contacts are positioned downward. The first loaded card (27) is positioned at the bottom of the stack of cards. A cap (28) is positioned on the lower extremity of the hopper. A piston (29) passes through the cap and bears against the lower level of the card stack and thus maintains the upper level of the card stack close to the upper extremity (23) of the hopper. The upper extremity (23) of the hopper is easily accessible. An air suction arm (30) picks up the card (20) with contacts facing downward close to the upper extremity (23) of the hopper to load it on the upper level of the card stack (26).

Figure 5 shows the step of providing the hopper (21) with retaining means according to the invention. A cap (33) is inserted into the upper extremity (23) of the hopper. Then filling balls (34) are introduced using a filling head (35) and compressed air into the empty part of the body of the hopper. The filling balls are introduced through an openable window (36) of the cap (28) positioned on the lower extremity (22) of the hopper.

Figure 6 represents the step of removing the piston (29) from the hopper (21) containing the stack of cards (26). The part of the body of the hopper that does not contain cards is loaded with filling balls (34) and the cap (28) is positioned on the lower extremity of the hopper. The piston (29) is removed through the openable window (36) of the cap (28). The shape of the piston (29) allows it to be withdrawn easily through the filling balls (34).

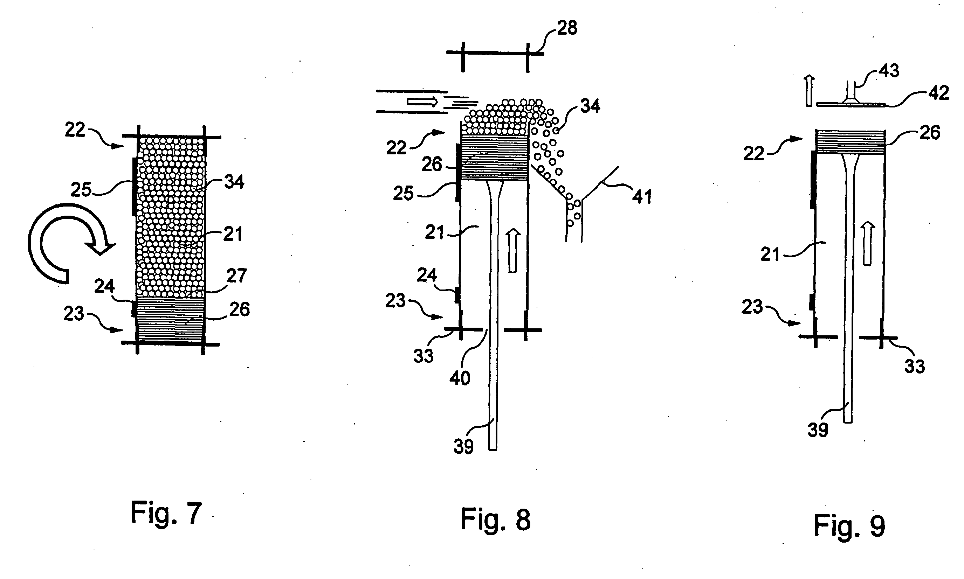

Figure 7 represents the step of turning the hopper (21) upside down. This operation can be performed manually by an operator, or alternatively by a machine. The exterior orientation means (24) and (25) allow the operator to be sure of the correct orientation of the hopper (21). When the step of turning the hopper upside down is accomplished, the stack of cards (26) is positioned in the lower part of the body of the hopper. The last loaded card is at the bottom of the stack of cards (26), whereas the first loaded card (27) is at the top. The faces of the cards having external contacts are orientated upward. The filling balls (34) are positioned in the upper part of the body of the hopper (21).

Figure 8 represents the step of removing the filling balls (34) from the hopper (21). The cap (28) positioned on the extremity (22) of the hopper is removed. A piston (39) is introduced in the hopper through the openable window (40) of the cap (33) positioned on the extremity (23). The piston bears against the lowest card of the stack of cards and pushes the stack of cards (26) up. In turn, the stack of cards (26) pushes the filling balls (34) out of the body of the hopper (21). Compressed air allows fast removal of the filling balls (34) that are collected by a collecting device (41).

Figure 9 represents the step of unloading a card (42) from the hopper (21). The piston (39) bears against the lowest card of the stack of cards (26) and thus maintains the upper level of the stack of cards (26) close to the extremity (22) of the hopper. The open extremity (22) of the hopper allows easy access to the upper level of the stack of cards (26). An air suction arm (43) approaches the extremity (24) of the hopper and picks up the card (42) on top of the stack of cards (26).

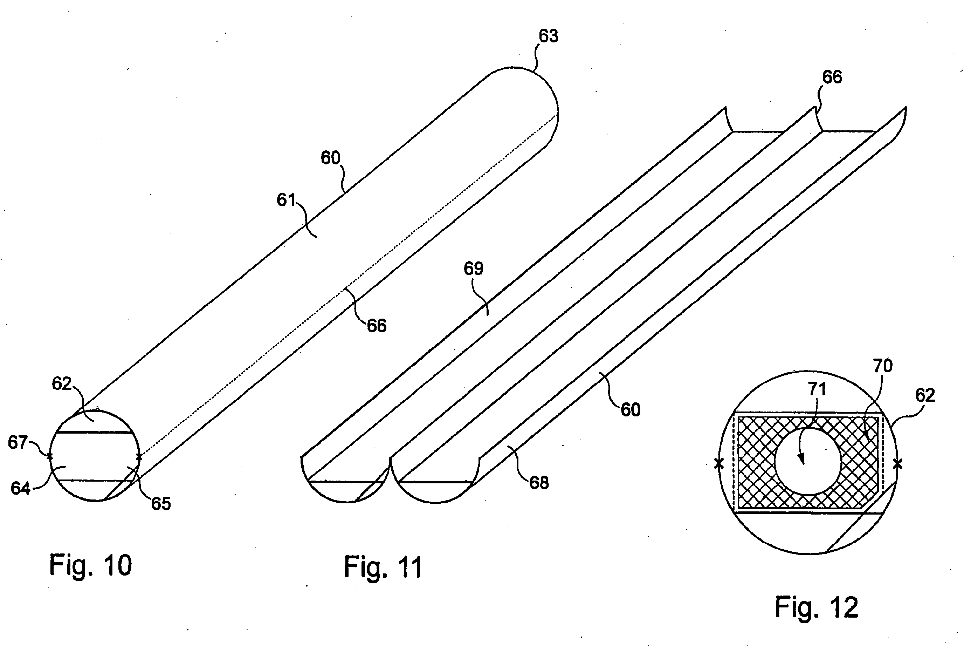

Figure 10 represents a schematic view of a hopper (60) according to a preferred embodiment of the invention. The hopper (60) comprises a hollow and generally cylinder-shaped body (61) provided with two open extremities (62) and (63). The interior of the body (61) has an internal cavity (64) designed to give a stack of cards 0.75 mm clearance on all sides. On the represented embodiment, the hopper is designed to contain SIM cards. The shape of the internal cavity (64) includes a shape (65) to fit the cropped corner of the SIM cards, thus enabling only one positioning of the cards inside the hopper (60). The body (61) of the hopper has two hinges (66) and (67) on two generator lines positioned opposite each other on a diameter of the body (61).

Figure 11 represents the hopper (60) in an open configuration, with the two halves (68) and (69) of the body (61) being linked by one of the hinges (66).

Figure 12 represents one extremity (62) of the hopper containing a SIM card (70). The empty space (71) required for easy access to the card (70) by an air suction arm is shown.

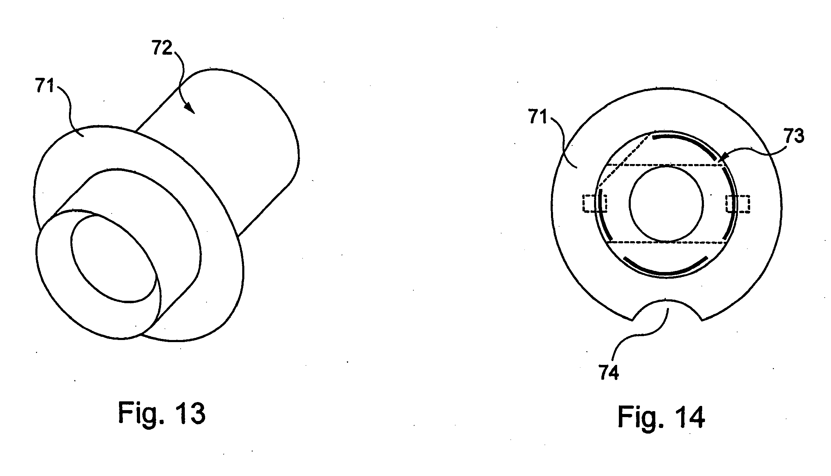

Figure 13 represents a cap (71) for an extremity (62) or (63) of the hopper (60). The cap has a "push fit" section (72) with prongs (not represented). The size of the cap (71) is adapted to fit inside an extremity (62) or (63) of the body of the hopper.

Figure 14 also shows the cap (71), and indicates the position and size of the prongs (73). The cap is also provided with an orientation means (74).

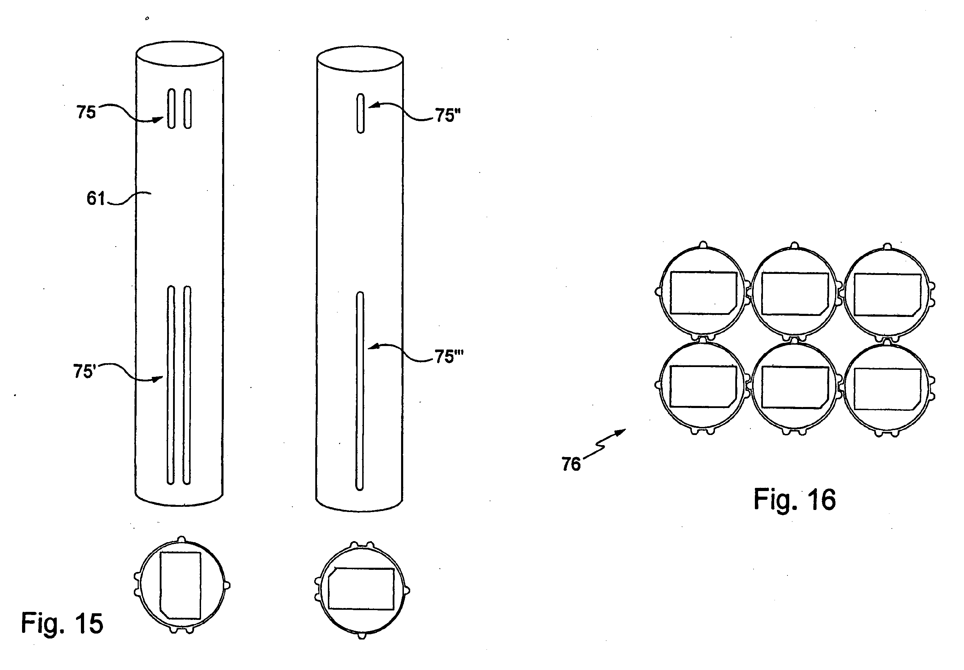

Figure 15 shows an example of an exterior orientation means (75), (75'), (75") and (75"') for the body of the hopper (60). These orientation means (75), (75'), (75") and (75"') allow the distinction of the two extremities of the hopper (60), and also allow the identification of the orientation of the body (61) about its axis. They can be sensed by a machine, or visualized by a human operator.

Figure 16 shows a group (76) of 6 hoppers linked together for storage. According to the embodiment represented, the exterior orientation means (75), (75'), (75") and (75"') are also a means of attachment that are used to link the hoppers together.

Of course, the present invention is in no way limited to the embodiments described and represented, but encompasses, on the contrary, any variant form within the capability of the person skilled in the art. In particular, the various embodiments may be combined. In particular, the invention can be applied to the handling of electronic cards of any formats, including microcircuit cards with or without contacts, and flash memory cards.

## Claims

1. A method for handling a plurality of electronic cards (26) with a hopper (21) comprising a hollow body with first and second open opposite extremities (22, 23), including the following steps :
- loading the plurality of electronic cards as a card stack in the hopper through the first open extremity (23) of the hopper in a first configuration where this first open extremity is at a higher level than the second open extremity (22),
- moving the hopper into a second configuration where the second open extremity (22) is at a higher level than the first open extremity (23), while maintaining the cards inside the hopper,
- unloading at least a part of the plurality of cards through this second open extremity (22).

2. A method according to claim 1 wherein the hopper (21) is at no more than 30° with respect to the vertical, in both first and second configurations.

3. A method according to claim 2 wherein the hopper (21) is substantially vertical in both first and second configurations.

4. A method according to any of claims 1 to 3 wherein the step of moving the hopper (21) into a second configuration where the second extremity (22) is at a higher level than the first extremity (23) while maintaining the cards (26) inside the hopper (21) includes the steps of
providing the hopper (21) with retaining means (34) to limit the movements of the cards (26) after the loading step
- removing these retaining means (34) before the unloading step.

5. A method according to claim 4 wherein
- the step of providing retaining means (34) includes closing the first extremity (23) of the hopper (21) with a removable cap (33).
- and the step of removing retaining means (34) includes removing a removable cap (28) from the second extremity (22).

6. A method according to either claim 4 or claim 5 wherein the step of providing retaining means (34) includes filling an empty part of the body of the hopper (21) with filling material (34).

7. A method according to any of claims 4 to 6 wherein the step of removing retaining means (34) includes removing the filling material (34) from the body of the hopper (21).

8. A method according to any of claims 1 to 7 wherein the loading step includes maintaining the upper level of the card stack close to the first extremity (23) with maintaining means (34) introduced through the second extremity (22) of the hopper (21).

9. A method according to any of claims 1 to 8 wherein the unloading step includes maintaining the upper level of the card stack close to the second extremity (22) with maintaining means (34) introduced through the first extremity (23) of the hopper (21).

10. A method according to any of claims 1 to 9 wherein the step of moving the hopper (21) from the first configuration into a second configuration is done manually.

11. A method according to any of claims 1 to 10 wherein the loading step includes using an air suction arm (30) to load the cards (26).

12. A method according to any of claims 1 to 11 wherein the unloading step includes using an air-suction arm (30) to unload the cards (26).

13. A method according to any of claims 1 to 12 wherein the step of moving the hopper (21) further includes the step of delivering the hopper (21) to another treatment area after the loading step and before the unloading step.

14. A method according to claim 13 wherein the hopper (21) is used as a temporary storage element for delivery to the premises of a client for said other treatment.

15. A method according to any of claims 1 to 14 wherein the step of moving the hopper (21) further includes the step of storing the cards (26) in the hopper (21) after the loading step and before the unloading step.

16. A method according to any of claims 1 to 15 wherein the method further includes transporting the cards (26) with a transport belt after the unloading step.

17. A method according to any of claims 1 to 16 wherein the method further includes moulding the cards (26) before the loading step.

18. A method according to any of claims 1 to 17 wherein the method further includes personalizing the cards (26) after the unloading step.

19. A method according to any of claims 1 to 18 wherein the cards (26) are about 0.8 mm thick and include a microcircuit (7).

20. A method according to any of claims 1 to 19 wherein the cards (26) include a microcircuit (1) provided with surface contacts (2).

21. A method according to claim 19 or claim 20 wherein the contacts (2) of the microcircuit cards (26) face downward before the loading step and face upward after the unloading step.

22. A method according to any of claims 1 to 21 wherein the cards (26) are smaller than ID-1 cards.

23. A method according to claim 22 wherein the card format is ID-000.

24. A method according to any of claims 1 to 23 wherein the cards (26) are mobile phone subscriber identification cards, for example SIM cards.

25. A hopper (21) comprising a hollow body adapted to include a stack of cards (26) of a predetermined format and provided with first and second opposite open extremities (22, 23),
**characterized in that** this hopper (21) being movable between a first configuration wherein the first open extremity (23) is at a higher level than the second open extremity (22) so that the cards (26) of the stack may be loaded in this hopper (21) through the first open extremity (23) and a second configuration wherein the second open extremity (22) is at a higher level than the first extremity (23) so that at least some of the cards (26) of the stack may be unloaded from the hopper (21) through this second open extremity (22), the hopper (21) is provided with means (28, 33, 34) maintaining the loaded cards (26) inside the hopper (21) when the hopper (21) is moved from the first to the second configuration.

26. A hopper (21) according to claim 25 and further comprising removable caps (28,33') adapted to close the extremities (22,23) and retain the stack of cards inside the hopper (21) during movements of the hopper (21).

27. A hopper according to claim 26 wherein the said removable caps (28,33) are pronged in order to fit inside the extremities of the hopper.

28. A hopper (21) according to claim 26 or claim 27 wherein the said removable caps (28,33) are provided with an orientation means allowing correct and fast orientation of the hopper (21).

29. A hopper (21) according to any of claims 26 to 28, wherein the removable caps (28,33) are provided with openings (36) to be traversed by elongated elements (29) intended to bear against the stack of cards (26).

30. A hopper (21) according to any of claims 26 to 29 wherein the hopper (21) further comprises removable filling material (34) adapted to fill the hollow body of the hopper (21) in addition to the stack of cards.

31. A hopper (21) according to claim 30 wherein the filling material (34) comprises compressible material.

32. A hopper (21) according to any of claims 25 to 31 wherein the body (61) is provided with exterior orientation means (75,75',75") for distinguishing the extremities from each other.

33. A hopper (21) according to any of claims 25 to 32 wherein the interior of the body has a shape allowing the cards to be positioned in only one orientation.

34. A hopper (21) according to any of claims 25 to 33 wherein the body is adapted to include a stack of cards of ID-000 format.

35. A hopper (21) according to any of claims 25 to 34 wherein the hopper body (61) is generally cylinder-shaped.

36. A hopper (21) according to claim 35 wherein the body (61) comprises an exterior orientation means (75,75',75") for identifying the orientation of the body (61) about its axis.

37. A hopper (21) according to any of claims 25 to 36 wherein the hopper body (61) comprises two complementary longitudinal parts (68,69), so that it can be opened longitudinally.

38. A hopper (21) according to any of claims 25 to 37 wherein the hopper body (61) is made by moulding, preferably injection-moulding of a polymer-based resin.

39. A hopper (21) according to any of claims 25 to 38 wherein the hopper (21) is made of transparent plastic material.

40. A hopper (21) according to any of claims 25 to 39 wherein the hopper body (61) is provided with attachment means (75,75") adapted to cooperate with attachment means of at least one other identical hopper (21).

41. A hopper (21) according to claim 40 wherein said attachment means (75,75") are linking means for storage.

42. A hopper assembly comprising a hopper (21) according to any of claims 25 to 41, this hopper assembly further comprising a removable longitudinal maintaining device to be introduced into the hollow body through one extremity of the hopper for maintaining the upper part of the card stack close to the other extremity.

43. A hopper assembly according to claim 42 wherein said removable maintaining device comprises a piston (39) or shaft.

44. A hopper assembly according to claim 42 or claim 43 and further comprising removable filling material (34) adapted to fill the hollow body of the hopper (21) in addition to the stack of cards wherein the said maintaining device (39) is profiled to allow its easy movement through the filling material (34).

45. A hopper assembly according to any of the claims 42 to 44 wherein the extremities of the hollow body (61) are provided with removable caps (71), at least one of the said caps (71) having an opening for letting the said maintaining device enter the hopper.

## Patentansprüche

1. Verfahren zur Handhabung mehrerer elektronischer Karten (26) mit einem Magazin (21), das einen Hohlkörper mit einem ersten und einem zweiten offenen Ende (22, 23), die sich gegenüberliegen, aufweist, das die folgenden Schritte umfasst:
- Laden der mehreren elektronischen Karten als einen Kartenstapel in das Magazin durch das erste offene Ende (23) des Magazins in einer ersten Konfiguration, in der sich dieses erste offene Ende auf einer höheren Ebene als das zweite offene Ende (22) befindet,
- Bewegen des Magazins in eine zweite Konfiguration, in der sich das zweite offene Ende (22) auf einer höheren Ebene als das erste offene Ende (23) befindet, wobei die Karten in dem Magazin gehalten werden,
- Entladen wenigstens eines Teils der mehreren Karten durch dieses zweite offene Ende (22).

2. Verfahren nach Anspruch 1, wobei das Magazin (21) sowohl in der ersten als auch in der zweiten Konfiguration um nicht mehr als 30° in Bezug auf die Vertikale geneigt ist.

3. Verfahren nach Anspruch 2, wobei das Magazin (21) sowohl in der ersten als auch in der zweiten Konfiguration im Wesentlichen vertikal ist.

4. Verfahren nach einem der Ansprüche 1 bis 3, wobei der Schritt des Bewegens des Magazins (21) in eine zweite Konfiguration, in der sich das zweite Ende (22) auf einer höheren Ebene als das erste Ende (23) befindet, während die Karten (26) in dem Magazin (21) gehalten werden, die folgenden Schritte umfasst:
- Versehen des Magazins (21) mit Rückhaltemitteln (34), um die Bewegungen der Karten (26) nach dem Ladeschritt zu begrenzen,
- Entfernen dieser Rückhaltemittel (34) vor dem Entladeschritt.

5. Verfahren nach Anspruch 4, wobei
- der Schritt des Vorsehens der Rückhaltemittel (34) das Schließen des ersten Endes (23) des Magazins (21) mit einer abnehmbaren Kappe (33), und
- der Schritt des Entfernens der Rückhaltemittel (34) das Entfernen der abnehmbaren Kappe (28) von dem zweiten Ende (22) umfasst.

6. Verfahren nach Anspruch 4 oder Anspruch 5, wobei der Schritt des Vorsehens der Rückhaltemittel das Befüllen eines leeren Teils des Körpers des Magazins (21) mit Füllmaterial (34) umfasst.

7. Verfahren nach einem der Ansprüche 4 bis 6, wobei der Schritt des Entfernens der Rückhaltemittel (34) das Entfernen des Füllmaterials (34) aus dem Körper des Magazins (21) umfasst.

8. Verfahren nach einem der Ansprüche 1 bis 7, wobei der Ladeschritt das Halten der oberen Ebene des Kartenstapels in der Nähe des ersten Endes (23) umfasst, wobei Haltemittel (34) durch das zweite Ende (22) des Magazins (21) eingeführt werden.

9. Verfahren nach einem der Ansprüche 1 bis 8, wobei der Entladeschritt das Halten der oberen Ebene des Kartenstapels in der Nähe des zweiten Endes (22) umfasst, wobei Haltemittel (38) durch das erste Ende (23) des Magazins (21) eingeführt werden.

10. Verfahren nach einem der Ansprüche 1 bis 9, wobei der Schritt des Bewegens des Magazins (21) aus der ersten Konfiguration in eine zweite Konfiguration manuell erfolgt.

11. Verfahren nach einem der Ansprüche 1 bis 10, wobei der Ladeschritt das Verwenden eines Luftsaugarms (30), um die Karten (26) zu laden, umfasst.

12. Verfahren nach einem der Ansprüche 1 bis 11, wobei der Entladeschritt das Verwenden eines Luftsaugarms (30), um die Karten (26) zu entladen, umfasst.

13. Verfahren nach einem der Ansprüche 1 bis 12, wobei der Schritt des Bewegens des Magazins (21) ferner den Schritt des Zuführens des Magazins (21) zu einem weiteren Behandlungsbereich nach dem Ladeschritt und vor dem Entladeschritt umfasst.

14. Verfahren nach Anspruch 13, wobei das Magazin (21) als ein Element zur vorübergehenden Lagerung bei der Lieferung zum Standort eines Kunden für die weitere Behandlung verwendet wird.

15. Verfahren nach einem der Ansprüche 1 bis 14, wobei der Schritt des Bewegens des Magazins (21) ferner den Schritt des Lagerns der Karten (26) in dem Magazin (21) nach dem Ladeschritt und vor dem Entladeschritt umfasst.

16. Verfahren nach einem der Ansprüche 1 bis 15, wobei das Verfahren ferner das Transportieren der Karten (26) mit einem Transportriemen nach dem Entladeschritt umfasst.

17. Verfahren nach einem der Ansprüche 1 bis 16, wobei das Verfahren ferner das Gießformen der Karten (26) vor dem Ladeschritt umfasst.

18. Verfahren nach einem der Ansprüche 1 bis 17, wobei das Verfahren ferner das Personalisieren der Karten nach dem Entladeschritt umfasst.

19. Verfahren nach einem der Ansprüche 1 bis 18, wobei die Karten eine Dicke von etwa 0,8 mm besitzen und eine Mikroschaltung (1) enthalten.

20. Verfahren nach einem der Ansprüche 1 bis 19, wobei die Karten (26) eine Mikroschaltung (1) enthalten, die mit Oberflächenkontakten (2) versehen ist.

21. Verfahren nach Anspruch 19 oder Anspruch 20, wobei die Kontakte (2) der Mikroschaltungskarten (26) vor dem Ladeschritt nach unten weisen und nach dem Entladeschritt nach oben weisen.

22. Verfahren nach einem der Ansprüche 1 bis 21, wobei die Karten (26) kleiner als ID-1-Karten sind.

23. Verfahren nach Anspruch 22, wobei das Kartenformat ID-000 ist.

24. Verfahren nach einem der Ansprüche 1 bis 23, wobei die Karten (26) Mobiltelephon-Teilnehmeridentifizierungskarten, beispielsweise SIM-Karten sind.

25. Magazin (21), das einen Hohlkörper umfasst, der dazu ausgelegt ist, einen Stapel von Karten (26) mit einem vorgegebenen Format aufzunehmen, und mit einem ersten und einem zweiten offenen Ende (22, 23), die sich gegenüberliegen, versehen ist,
**dadurch gekennzeichnet, dass** dieses Magazin (21) zwischen einer ersten Konfiguration, in der sich das erste offene Ende (23) auf einer höheren Ebene als das zweite offene Ende (22) befindet, so dass die Karten (26) des Stapels in dieses Magazin (21) durch die erste Öffnung (23) geladen werden können, und einer zweiten Konfiguration, in der sich das zweite offene Ende (22) auf einer höheren Ebene als das erste Ende (23) befindet, so dass wenigstens einige der Karten (26) des Stapels durch dieses zweite offene Ende (22) aus dem Magazin (21) entladen werden können, beweglich ist, wobei das Magazin (21) mit Mitteln (28, 33, 34) versehen ist, die die geladenen Karten (26) in dem Magazin (21) halten, wenn das Magazin (21) aus der ersten in die zweite Konfiguration bewegt wird.

26. Magazin (21) nach Anspruch 25, das ferner abnehmbare Kappen (28, 35) umfasst, die dazu ausgelegt sind, die Enden (22, 23) zu verschließen und den Stapel von Karten während der Bewegungen des Magazins (21) in dem Magazin (21) zu halten.

27. Magazin nach Anspruch 26, wobei die entnehmbaren Kappen (28, 33) Spitzen aufweisen, um in die Enden des Magazins zu passen.

28. Magazin (21) nach Anspruch 26 oder Anspruch 27, wobei die abnehmbaren Kappen (28, 33) mit einem Orientierungsmittel versehen sind, das eine korrekte und schnelle Orientierung des Magazins (21) ermöglicht.

29. Magazin (21) nach einem der Ansprüche 26 bis 28, wobei die abnehmbaren Kappen (28, 33) mit Öffnungen (36) versehen sind, durch die lang gestreckte Elemente (29) verlaufen können, die gegen den Stapel von Karten (26) drücken sollen.

30. Magazin (21) nach einem der Ansprüche 26 bis 29, wobei das Magazin (21) ferner entnehmbares Füllmaterial enthält, das dazu ausgelegt ist, den Hohlkörper des Magazins (21) zusätzlich zu dem Stapel von Karten zu füllen.

31. Magazin (21) nach Anspruch 30, wobei das Füllmaterial (34) komprimierbares Material umfasst.

32. Magazin (21) nach einem der Ansprüche 25 bis 31, wobei der Körper (61) mit äußeren Orientierungsmitteln (75, 75', 75") versehen ist, um die Enden voneinander zu unterscheiden.

33. Magazin (21) nach einem der Ansprüche 25 bis 32, wobei der Innenraum des Körpers eine Form hat, die ermöglicht, dass die Karten in nur einer einzigen Orientierung positioniert werden können.

34. Magazin (21) nach einem der Ansprüche 25 bis 33, wobei der Körper dazu ausgelegt ist, einen Stapel von Karten des ID-000-Formats aufzunehmen.

35. Magazin (21) nach einem der Ansprüche 25 bis 34, wobei der Magazinkörper (61) im Allgemeinen zylinderförmig ist.

36. Magazin (21) nach Anspruch 35, wobei der Körper (61) ein äußeres Orientierungsmittel (75, 75', 75") umfasst, um die Orientierung des Körpers (61) um seine Achse zu identifizieren.

37. Magazin (21) nach einem der Ansprüche 25 bis 36, wobei der Magazinkörper (61) zwei komplementäre longitudinale Abschnitte (68, 69) umfasst, so dass er longitudinal geöffnet werden kann.

38. Magazin (21) nach einem der Ansprüche 25 bis 37, wobei der Magazinkörper (61) durch Gießformen, vorzugsweise durch Spritzguss eines Harzes auf Polymerbasis, hergestellt wird.

39. Magazin (21) nach einem der Ansprüche 25 bis 38, wobei das Magazin (21) aus einem transparenten Kunststoff hergestellt ist.

40. Magazin (21) nach einem der Ansprüche 25 bis 39, wobei der Magazinkörper (61) mit Befestigungsmitteln (75, 75") versehen ist, die dazu ausgelegt sind, mit Befestigungsmitteln wenigstens eines anderen gleichen Magazins (21) zusammenzuwirken.

41. Magazin (21) nach Anspruch 40, wobei die Befestigungsmittel (75, 75") Verbindungsmittel für die Lagerung sind.

42. Magazinanordnung, die ein Magazin (21) nach einem der Ansprüche 25 bis 41 umfasst, wobei diese Magazinanordnung ferner eine entnehmbare longitudinale Haltevorrichtung umfasst, die in den Hohlkörper durch ein Ende des Magazins eingeführt werden soll, um den oberen Teil des Kartenstapels in der Nähe des anderen Endes zu halten.

43. Magazinanordnung nach Anspruch 42, wobei die entnehmbare Haltevorrichtung einen Kolben (39) oder einen Schaft umfasst.

44. Magazinanordnung nach Anspruch 42 oder Anspruch 43, die ferner entnehmbares Füllmaterial (34) umfasst, das dazu ausgelegt ist, den Hohlkörper des Magazins (21) zusätzlich zu dem Stapel von Karten zu füllen, wobei die Haltevorrichtung so profiliert ist, dass sie ihre einfache Bewegung durch das Füllmaterial (34) zulässt.

45. Magazinanordnung nach einem der Ansprüche 42 bis 44, wobei die Enden des Hohlkörpers (61) mit abnehmbaren Kappen (71) versehen sind, wobei wenigstens eine der Kappen eine Öffnung besitzt, durch die die Haltevorrichtung in das Magazin eintreten kann.

## Revendications

1. Procédé de gestion d'une pluralité de cartes électroniques (26) au moyen d'une trémie (21) comprenant un corps creux comportant des première et deuxième extrémités opposées (22, 23), comprenant les étapes consistant à :
- charger dans la trémie la pluralité de cartes électroniques sous la forme d'une pile de cartes par l'intermédiaire de la première extrémité ouverte (23) de la trémie, dans une première configuration dans laquelle la première extrémité ouverte est à un niveau plus élevé que la deuxième extrémité ouverte (22),
- déplacer la trémie vers une deuxième configuration dans laquelle la deuxième extrémité ouverte (22) est à un niveau plus élevé que la première extrémité ouverte (23), tout en maintenant les cartes à l'intérieur de la trémie,
- décharger au moins une partie de la pluralité de cartes par l'intermédiaire de cette deuxième extrémité ouverte (22).

2. Procédé selon la revendication 1, dans lequel la trémie (21) n'est pals orientée à plus de 30° de la verticale, à la fois dans les première et deuxième configurations.

3. Procédé selon la revendication 2, dans lequel la trémie (21) est sensiblement verticale à la fois dans les première et deuxième configurations.

4. Procédé selon l'une quelconque des revendications 1 à 3, dans lequel l'étape consistant à déplacer la trémie (21) vers une deuxième configuration dans laquelle la deuxième extrémité (22) est à niveau plus élevé que la première extrémité (23), tout en maintenant les cartes (26) à l'intérieur de la trémie (21), comprend les étapes consistant à :
- munir la trémie (21) de moyens de retenue (34) pour limiter les mouvements des cartes (26) après l'étape de chargement,
- retirer ces moyens de retenue (34) avant l'étape de déchargement.

5. Procédé selon la revendication 4, dans lequel
- l'étape consistant à prévoir des moyens de retenue (34) comprend la fermeture de la première extrémité (23) de la trémie (21) à l'aide d'un capuchon amovible (33),
- et l'étape consistant à retirer les moyens de retenue (34) consiste à retirer un capuchon amovible (28) de la deuxième extrémité (22).

6. Procédé selon la revendication 4 ou la revendication 5, dans lequel l'étape consistant à prévoir des moyens de retenue (34) consiste à remplir une partie vide du corps de la trémie (21) d'un matériau de remplissage (34).

7. Procédé selon l'une quelconque des revendications 4 à 6, dans lequel l'étape consistant à retirer les moyens de retenue (34) consiste à retirer le matériau de remplissage (34) du corps de la trémie (21).

8. Procédé selon l'une quelconque des revendications 1 à 7, dans lequel l'étape de chargement consiste à maintenir le niveau supérieur de la pile de cartes à proximité de la première extrémité (23) à l'aide de moyens de maintien (34) introduits par l'intermédiaire de la deuxième extrémité (22) de la trémie (21).

9. Procédé selon l'une quelconque des revendications 1 à 8, dans lequel l'étape de déchargement consiste à maintenir le niveau supérieur de la pile de cartes à proximité de la deuxième extrémité (22) à l'aide de moyens de maintien (34) introduits par l'intermédiaire de la première extrémité (23) de la trémie (21).

10. Procédé selon l'une quelconque des revendications 1 à 9, dans lequel l'étape consistant à déplacer la trémie (21) de la première configuration vers la deuxième configuration est effectuée manuellement.

11. Procédé selon l'une quelconque des revendications 1 à 10, dans lequel l'étape de chargement consiste à utiliser un bras aspirant de l'air (30) pour charger les cartes (26).

12. Procédé selon l'une quelconque des revendications 1 à 11, dans lequel l'étape de déchargement consiste à utiliser un bras aspirant de l'air (30) pour décharger les cartes (26).

13. Procédé selon l'une quelconque des revendications 1 à 12, dans lequel l'étape consistant à déplacer la trémie (21) comprend en outre l'étape consistant à livrer la trémie (21) à une autre zone de traitement après l'étape de chargement et avant l'étape de déchargement.

14. Procédé selon la revendication 13, dans lequel la trémie (21) est utilisée comme élément de stockage temporaire pour la livraison aux locaux d'un client en vue dudit autre traitement.

15. Procédé selon l'une quelconque des revendications 1 à 14, dans lequel l'étape de déplacement de la trémie (21) comprend en outre l'étape consistant à stocker les cartes (26) dans la trémie (21) après l'étape de chargement et avant l'étape de déchargement.

16. Procédé selon l'une quelconque des revendications 1 à 15, dans lequel le procédé consiste en outre à transporter les cartes (26) à l'aide d'une courroie de transport après l'étape de déchargement.

17. Procédé selon l'une quelconque des revendications 1 à 16, dans lequel le procédé consiste en outre à mouler les cartes (26) avant l'étape de chargement.

18. Procédé selon l'une quelconque des revendications 1 à 17, dans lequel le procédé consiste en outre à personnaliser les cartes (26) après l'étape de déchargement.

19. Procédé selon l'une quelconque des revendications 1 à 18, dans lequel les cartes (26) ont une épaisseur d'environ 0,8 mm et comportent un microcircuit (1).

20. Procédé selon l'une quelconque des revendications 1 à 19, dans lequel les cartes (26) comportent un microcircuit (1) muni de contacts superficiels (2).

21. Procédé selon la revendication 19 ou 20, dans lequel les contacts (2) des cartes de microcircuits (26) sont orientés vers les bas avant l'étape de chargement et sont orientés vers le haut après l'étape de déchargement.

22. Procédé selon l'une quelconque des revendications 1 à 21, dans lequel les cartes (26) sont plus petites que les cartes d'identité ID-1.

23. Procédé selon la revendication 22, dans lequel le format de carte est le format ID-000.

24. Procédé selon l'une quelconque des revendications 1 à 23, dans lequel les cartes (26) sont des cartes d'identification d'abonné mobile, par exemple des cartes SIM.

25. Trémie (21) comprenant un corps creux apte à contenir une pile de cartes (26) d'un format prédéterminé et muni de première et deuxième extrémités ouvertes opposées (22, 23),
**caractérisée en ce que** cette trémie (21) peut être déplacée entre une première configuration dans laquelle la première extrémité ouverte (23) est à un niveau plus élevé que la deuxième extrémité ouverte (22) afin que les cartes (26) de la pile puissent être chargées dans cette trémie (21) par l'intermédiaire de la première extrémité ouverte (23), et une deuxième configuration dans laquelle la deuxième extrémité ouverte (22) est à un niveau plus élevé que la première extrémité (23) afin qu'au moins certaines des cartes (26) de la pile puissent être déchargées de la trémie (21) par l'intermédiaire de cette deuxième extrémité ouverte (22), la trémie (21) étant munie de moyens (28, 33, 34) maintenant les cartes chargées (26) à l'intérieur de la trémie (21) pendant que la trémie (21) est déplacée de la première vers la deuxième configuration.

26. Trémie (21) selon la revendication 25, comprenant en outre des capuchons amovibles (28, 33) aptes à fermer les extrémités (22, 23) et à retenir la pile de cartes à l'intérieur de la trémie (21) pendant les mouvements de la trémie (21).

27. Trémie selon la revendication 26, dans laquelle lesdits capuchons amovibles (28, 33) sont dentelés de façon à pouvoir être ajustés à l'intérieur des extrémités de la trémie.

28. Trémie (21) selon la revendication 26 ou 27, dans laquelle lesdits capuchons amovibles (28, 33) sont munis de moyens d'orientation permettant une orientation correcte et rapide de la trémie (21).

29. Trémie (21) selon l'une quelconque des revendications 26 à 28, dans laquelle les capuchons amovibles (28, 33) sont munis d'ouvertures (36) pouvant être traversées par des éléments oblongs (29) destinés à appuyer sur la pile de cartes (26).

30. Trémie (21) selon l'une quelconque des revendications 26 à 29, dans laquelle la trémie (21) comprend en outre un matériau de remplissage amovible (34) apte à remplir le corps creux de la trémie (21) en plus de la pile de cartes.

31. Trémie (21) selon la revendication 30, dans laquelle le matériau de remplissage (34) comprend un matériau compressible.

32. Trémie (21) selon l'une quelconque des revendications 25 à 31, dans laquelle le corps (61) est muni de moyens d'orientation extérieurs (75, 75', 75") pour distinguer les extrémités l'une de l'autre.

33. Trémie (21) selon l'une quelconque des revendications 25 à 32, dans laquelle l'intérieur du corps présente une forme permettant de positionner les cartes selon une seule orientation.

34. Trémie (21) selon l'une quelconque des revendications 25 à 33, dans laquelle le corps est apte à comporter une pile de cartes de format ID-000.

35. Trémie (21) selon l'une quelconque des revendications 25 à 34, dans laquelle le corps de trémie (61) présente une forme globalement cylindrique.

36. Trémie (21) selon la revendication 35, dans laquelle le corps (61) comprend des moyens d'orientation extérieurs (75, 75', 75") pour identifier l'orientation du corps (61) par rapport à son axe.

37. Trémie (21) selon l'une quelconque des revendications 25 à 36, dans laquelle le corps de trémie (61) comprend deux parties longitudinales complémentaires (68, 69) afin qu'elle puisse être ouverte longitudinalement.

38. Trémie (21) selon l'une quelconque des revendications 25 à 37, dans laquelle le corps de trémie (61) est réalisé par moulage, de préférence par moulage par injection, d'une résine à base de polymère.

39. Trémie (21) selon l'une quelconque des revendications 25 à 38, dans laquelle la trémie (21) est faite d'une matière plastique transparente.

40. Trémie (21) selon l'une quelconque des revendications 25 à 39, dans laquelle le corps de trémie (61) est muni de moyens de fixation (75, 75") aptes à coopérer avec des moyens de fixation d'au moins une autre trémie identique.

41. Trémie (21) selon la revendication 40, dans laquelle lesdits moyens de fixation (75, 75") sont des moyens de liaison pour le stockage.

42. Assemblage de trémie comprenant une trémie (21) selon l'une quelconque des revendications 25 à 41, cet assemblage de trémie comprenant en outre un dispositif de maintien longitudinal amovible destiné à être introduit dans le corps creux par l'intermédiaire d'une extrémité de la trémie afin de maintenir la partie supérieure de la pile de cartes à proximité de l'autre extrémité.

43. Assemblage de trémie selon la revendication 42, dans lequel ledit dispositif de maintien amovible comprend un piston (39) ou un arbre.

44. Assemblage de trémie selon la revendication 42 ou 43, et comprenant en outre un matériau de remplissage amovible (34) apte à remplir le corps creux de la trémie (21) en plus de la pile de cartes, dans lequel ledit dispositif de maintien est profilé de façon qu'il puisse être facilement déplacé à travers le matériau de remplissage (34)

45. Assemblage de trémie selon l'une quelconque des revendications 42 à 44, dans lequel les extrémités du corps creux (61) sont munies de capuchons amovibles (71), au moins l'un desdits capuchons ayant une ouverture pour permettre audit dispositif de maintien de pénétrer dans la trémie.
